# EUROPÄISCHE PATENTSCHRIFT

(11) **EP 3 030 055 B1**
(45) Veröffentlichungstag und Bekanntmachung des Hinweises auf die Patenterteilung: **27.03.2019**
(21) Anmeldenummer: 15191211.0
(22) Anmeldetag: 23.10.2015
(51) Int. Cl.: H05K 1/02, H05K 13/04, F21S 41/19, F21S 41/147, F21S 41/39, H05K 3/30, H01L 33/48, H01L 33/60

(54) **VERFAHREN ZUR HERSTELLUNG EINER KOMPONENTE EINER BELEUCHTUNGSEINRICHTUNG FÜR EIN KRAFTFAHRZEUG**
METHOD FOR PRODUCING A COMPONENT OF A LIGHTING DEVICE FOR A MOTOR VEHICLE
PROCEDE DE FABRICATION D'UN COMPOSANT D'UN DISPOSITIF D'ECLAIRAGE POUR UN VEHICULE AUTOMOBILE

(30) Priorität: 01.12.2014 DE 102014224494
(43) Veröffentlichungstag der Anmeldung: 08.06.2016
(73) Patentinhaber: Automotive Lighting Reutlingen GmbH, 72762 Reutlingen (DE)
(72) Erfinder: Otto, Carsten, 73733 Esslingen (DE); Brendle, Matthias, 72074 Tübingen (DE); Maier, Andreas, 72379 Hechingen (DE); Heusing, Klaus, 98596 Brotterode-Trusetal (DE); Kress, Andreas, 72074 Tübingen (DE)
(74) Vertreter: DREISS Patentanwälte PartG mbB

(56) Entgegenhaltungen:
- EP-A2- 1 003 212
- WO-A1-2014/153576
- US-A1- 2010 053 929
- US-A1- 2013 245 988

## Beschreibung

### Stand der Technik

Die Erfindung betrifft ein Verfahren zur Herstellung einer Komponente einer Beleuchtungseinrichtung nach dem Oberbegriff des Anspruchs 1.

Verfahren zum Aufbringen von Bauteilen, insbesondere von SMD-Bauteilen (SMD: Surface Mounted Device), auf eine Leiterplatte sind allgemein bekannt. Beispielsweise werden SMD-LEDs (Surface Mounted Device - Light Emitting Diode) an einer Zielkoordinate auf der Leiterplatte abgelegt und in einem nachfolgenden Schritt durch Aufschmelzen von Lot, beispielsweise durch das sogenannte Reflow-Löten, materialschlüssig und leitend mit der Leiterplatte verbunden. Beim Reflow-Löten können sich die abgelegten SMD-LEDs verschieben, was die Toleranz der Anordnung vergrößert.

Die WO 2014/153576 A1 betrifft ein Verfahren, bei dem eine SMD-LED orientiert an einem oder mehreren Referenzpunkten eines Schaltungsträgers an dem Schaltungsträger positioniert wird. Hierzu wird zunächst eine Position eines lichtemittierenden Bereichs optisch detektiert und die SMD-LED am Schaltungsträger in Abhängigkeit von der detektierten Position des lichtemittierenden Bereichs montiert. Zumindest einer der Referenzpunkte wird zur Positionierung und zur Befestigung eines optischen Systems für die wenigstens eine SMD-LED verwendet.

EP 1 003 212 A2 offenbart, dass ein Lichterzeugungselement an einer Befestigungsposition auf einem Board in Abhängigkeit von ermittelten Koordinaten eines Konturreferenzpunkts positioniert wird. Das Lichterzeugungselement wird vor der Festlegung zu einer Lichterzeugung betrieben.

US 2010/0053929 A1 offenbart gemäß dem dortigen Anspruch 1 die Anordnung eines LED-Chips auf einer Leiterplatte im Rahmen einer Kapselung ("packaging") des LED-Chips. Reflektoren 150 (1) sind integraler Bestandteil der Leiterplatte.

Des Weiteren ist bekannt, dass Lichtquellenbauteile in Form von LEDs auch hohe Toleranzen bezüglich der Anordnung eines lichtemittierenden Bereichs zu dem Gehäuse des Lichtquellenbauteils selbst aufweisen. Das bedeutet, dass insbesondere günstigere Lichtquellenbauteile höhere Toleranzen bezüglich der Anordnung des lichtemittierenden Bereichs zu den Außenkonturen des Lichtquellenbauteils sowie zu den Lötkontakten des Lichtquellenbauteils aufweisen.

Bei der Herstellung von Kraftfahrzeugscheinwerfern müssen hingegen geringe Toleranzen hinsichtlich vorgegebener Abstrahlcharakteristiken eingehalten werden. Insbesondere die sogenannte Hell-Dunkel-Grenze für ein Abblendlicht eines Kraftfahrzeug-Frontscheinwerfers stellt eine solche Abstrahlcharakteristik dar und muss exakt eingehalten werden.

Aufgabe der Erfindung ist es daher, ein Verfahren bereitzustellen, mit dem die vorgenannten Toleranzen verringert werden können.

### Offenbarung der Erfindung

Die der Erfindung zugrunde liegende Aufgabe wird nach dem Anspruch 1 gelöst.

Vorteilhafte Weiterbildungen sind in den Unteransprüchen angegeben. Des Weiteren finden sich für die Erfindung wichtige Merkmale in der nachfolgenden Beschreibung und Zeichnungen, wobei die Merkmale sowohl in Alleinstellung als auch in unterschiedlichen Kombinationen für die Erfindung wichtig sein können, ohne dass hierauf nochmals explizit hingewiesen wird.

Dadurch, dass in einem ersten Schritt eine Lage eines lichtemittierenden Bereichs eines SMD-Halbleiterlichtquellenbauteils, das auf einer Leiterplatte angeordnet ist, bezüglich der Leiterplatte ermittelt wird und in einem zweiten Schritt ein optisches Element und die Leiterplatte in Abhängigkeit von der ermittelten Lage des lichtemittierenden Bereichs zueinander positioniert und miteinander verbunden werden, können auf der einen Seite vorgelagerte Fertigungsschritte vereinfacht werden und auf der anderen Seite können günstigere SMD-Halbleiterlichtquellenbauteile verwendet werden. Mithin ergibt sich eine günstigere Beleuchtungseinrichtung für ein Kraftfahrzeug, wobei gleichzeitig die Präzision der Abstrahlcharakteristik erhöht wird. Darüber hinaus kann eine leichtere Beleuchtungseinrichtung geschaffen werden. Des Weiteren können Zentrierelemente sowie Zentriergeometrien entfallen, was den Produktionsaufwand und die Produktionskosten positiv beeinflusst.

In einer vorteilhaften Ausführungsform wird in einem ersten Schritt eine Markierung, die die Lage des lichtemittierenden Bereichs zu der Leiterplatte repräsentiert, auf die Leiterplatte aufgebracht. In dem zweiten Schritt werden das optische Element und die Leiterplatte in Abhängigkeit von der Markierung zueinander positioniert und miteinander verbunden. In dieser vorteilhaften Ausführungsform können der erste Schritt und der zweite Schritt voneinander getrennt werden, was die Flexibilität bei der Fertigung der Komponente der Beleuchtungseinrichtung wesentlich erhöht.

In einer vorteilhaften Weiterbildung umfasst die Markierung zumindest eine Linie, die im Wesentlichen parallel zu einer Kante des lichtemittierenden Bereichs des SMD-Halbleiterlichtquellenbauteils ist. Die Linie stellt ein einfach erkennbares geometrisches Objekt dar, mittels dessen die Lage des lichtemittierenden Bereichs auf einfache Art und Weise auf die Leiterplatte aufbringbar ist.

In einer vorteilhaften Weiterbildung umfasst die Markierung eine maschinenlesbare Kodierung, die die Lage des lichtemittierenden Bereichs zu der Leiterplatte beschreibt. Diese Information kann beispielsweise auch nach der Herstellung der Komponente zur Qualitätskontrolle verwendet werden.

In einer vorteilhaften Ausführungsform weist das optische Element eine Referenzgeometrie auf, die derart ausgestaltet ist, dass in Abhängigkeit von der Referenzgeometrie das optische Element und die Leiterplatte zueinander ausrichtbar sind. Die Referenzgeometrie kann vorteilhaft in dem zweiten Schritt dazu verwendet werden, um die Leiterplatte und das optische Element präzise zueinander auszurichten.

In einer vorteilhaften Ausführungsform korrespondieren die Referenzgeometrie und die Markierung auf der Leiterplatte.

In einer vorteilhaften Ausführungsform wird die Referenzgeometrie des optischen Elements von demselben Werkzeug erzeugt und/oder bearbeitet wie ein für das SMD-Halbleiterlichtquellenbauteil optisch wirksamer Bereich des optischen Elements. Hierdurch kann vorteilhaft eine hohe Präzision bezüglich der Anordnung der Referenzgeometrie und des optisch wirksamen Bereichs des optischen Elements sichergestellt werden. Entsprechend können die hohen Toleranzen bezüglich der Anordnung und der Ausbildung des SMD-Halbleiterlichtquellenbauteils ausgeglichen werden.

Weitere Merkmale, Anwendungsmöglichkeiten und Vorteile der Erfindung ergeben sich aus der nachfolgenden Beschreibung der Ausführungsbeispiele der Erfindung, die in den Figuren der Zeichnung dargestellt sind. Alle beschriebenen oder dargestellten Merkmale bilden hierbei für sich oder in beliebiger Kombination den Gegenstand der Erfindung, unabhängig von ihrer Zusammenfassung in den Patentansprüchen und deren Rückbeziehung sowie unabhängig von ihrer Formulierung bzw. Darstellung in der Beschreibung bzw. in der Zeichnung. Für funktionsäquivalente Größen und Merkmale werden in allen Figuren, auch bei unterschiedlichen Ausführungsformen, die gleichen Bezugszeichen verwendet.

Nachfolgend werden beispielhafte Ausführungsformen der Erfindung unter Bezugnahme auf die Zeichnung erläutert. In der Zeichnung zeigen:
- Figur 1: ein schematisches Ablaufdiagramm;
- Fig. 2 und 3: in schematischer Draufsicht ein SMD-Halbleiterlichtquellenbauteil auf einer Leiterplatte;
- Figur 4: in schematischer Draufsicht die Leiterplatte mit einem darauf angeordneten optischen Element; und
- Figur 5: eine schematische Schnittansicht des in Figur 4 dargestellten Gegenstands.

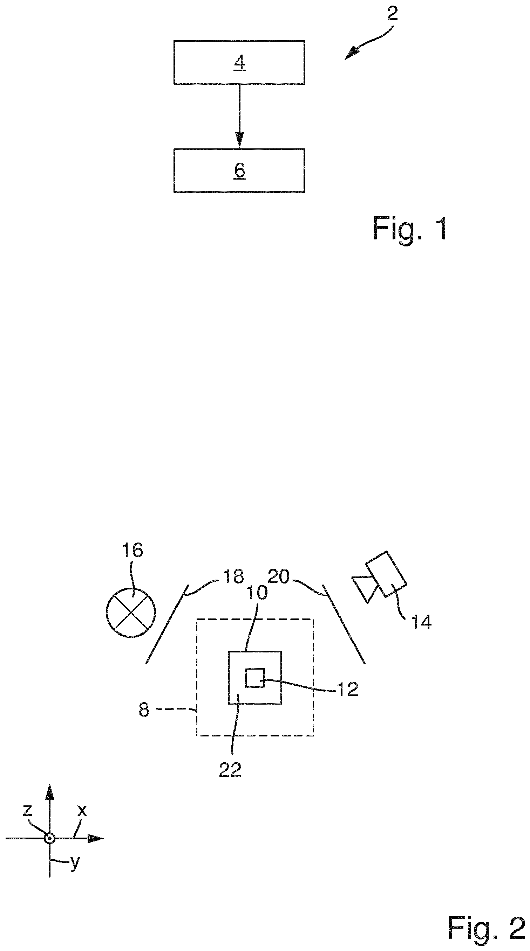

Figur 1 zeigt ein schematisches Ablaufdiagramm 2 eines Verfahrens zur Herstellung einer Komponente einer Beleuchtungseinrichtung für ein Kraftfahrzeug. In einem ersten Schritt 4 wird eine Lage eines lichtemittierenden Bereichs eines SMD-Halbleiterlichtquellenbauteils auf einer Leiterplatte ermittelt. In einem zweiten Schritt 6 werden ein optisches Element und die Leiterplatte in Abhängigkeit von der ermittelten Lage des lichtemittierenden Bereichs zueinander positioniert und miteinander verbunden.

Der erste Schritt 4 und der zweite Schritt 6 können auf derselben Fertigungsstation erfolgen. Selbstverständlich können die Schritte 4 und 6 auch auf separaten Fertigungsstationen ausgeführt werden.

Figur 2 zeigt in schematischer Draufsicht entgegen einer z-Richtung die Leiterplatte 8. Des Weiteren ist das SMD-Halbleiterlichtquellenbauteil 10 gezeigt, das den lichtemittierenden Bereich 12 aufweist. Die Außenkonturen in einer xy-Ebene des SMD-Halbleiterlichtquellenbauteils 10 und/oder des lichtemittierenden Bereichs 14 sind in der Figur 2 im Wesentlichen quadratisch dargestellt, können aber selbstverständlich auch jede andere rechteckige Form oder andersartige geometrische Form aufweisen.

Mittels einer Aufnahmekamera 14 wird ein Bild des SMD-Halbleiterlichtquellenbauteils 10 aufgenommen. Das Bild wird derart ausgewertet, dass eine Erkennung der Anordnung des SMD-Halbleiterlichtquellenbauteils 10 zu der Leiterplatte 8 und/oder eine Anordnung des lichtemittierenden Bereichs 12 zu der Leiterplatte 8 auf Basis des Bildes erfolgt.

Das SMD-Halbleiterlichtquellenbauteil 10 wird mittels einer Lichtquelle 16 beleuchtet, um das Bild aufzunehmen. Umfasst das SMD-Halbleiterlichtquellenbauteil 10 beispielsweise einen Phosphorkonverter als lichtemittierenden Bereich 12, so sorgt ein Blaufilter 18 vor der Lichtquelle 16 dafür, dass das SMD-Halbleiterlichtquellenbauteil 10 mit blauem Licht beleuchtet wird. Zusätzlich sorgt ein Gelbfilter 20 dafür, dass das von dem Phosphorkonverter 12 reflektierte Licht mit einem hohen Kontrast gegenüber einem weiteren Bereich 22, der zu den Außengrenzen des SMD-Halbleiterlichtquellenbauteils 10 hin angeordnet ist, aufgenommen wird. Insbesondere wenn dieser weitere Bereich 22 aus einem im Wesentlichen schwach reflektierenden Material wie beispielsweise einer Vergussmasse wie Silikon besteht, erhöht sich der Kontrast gegenüber dem Phosphorkonverter und damit gegenüber dem lichtemittierenden Bereich 12, stark.

Mittels des aufgenommenen Bildes kann die Lage des lichtemittierenden Bereichs 12 in einer xy-Ebene zu der Leiterplatte 8 ermittelt werden. Selbstverständlich kann die gezeigte Anordnung auch anders ausgestaltet sein. Insbesondere die Filter 18 und 20 können anders ausgestaltet sein oder wegfallen. Selbstverständlich kann auch eine weitere Lichtquelle, die alternativ zur Lichtquelle 16 verwendet wird, die Anordnung ergänzen.

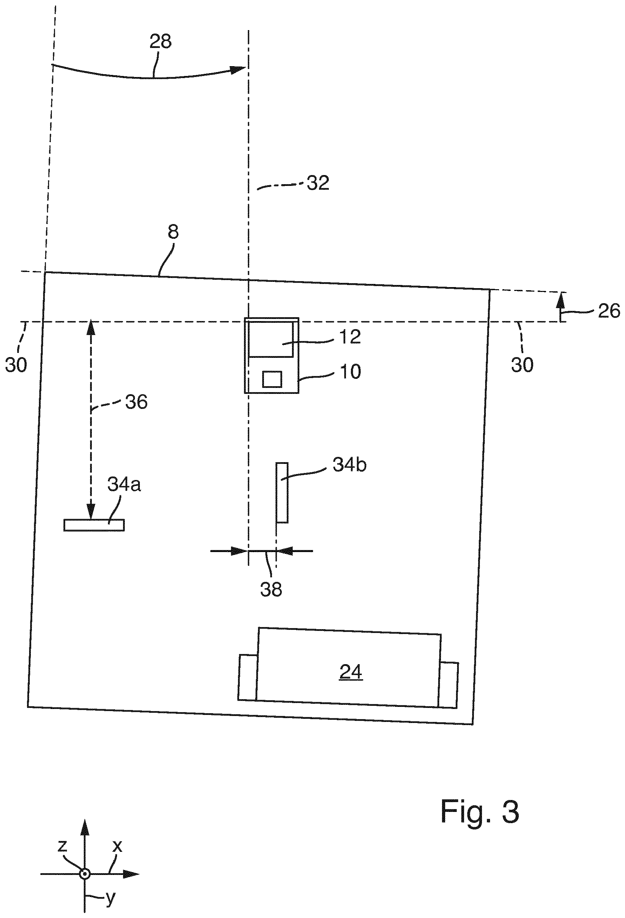

Figur 3 zeigt in schematischer Draufsicht aus einer z-Richtung das auf der Leiterplatte 8 angeordnete SMD-Halbleiterlichtquellenbauteil 10. Auf der Leiterplatte 8 ist des Weiteren ein Stecker 24 angeordnet, der elektrisch leitend über die Leiterplatte 8 mit dem SMD-Halbleiterlichtquellenbauteil 10 verbunden ist. Über den Stecker 24 wird das SMD-Halbleiterlichtquellenbauteil 10 mit Strom versorgt. In Figur 3 ist der lichtemittierende Bereich 12 mit seinen Kanten gegenüber den jeweiligen Außenkanten der Leiterplatte 8 um einen Winkel 26 und einen Winkel 28 verdreht angeordnet. Beispielhaft charakterisieren die Linien 30 und 32 die Lage des lichtemittierenden Bereichs 12 in einem Koordinatensystem, womit diese Linien 30 und 32 zu einer Ausrichtung des optischen Elements, wie in nachfolgender Figur erläutert, verwendet werden können.

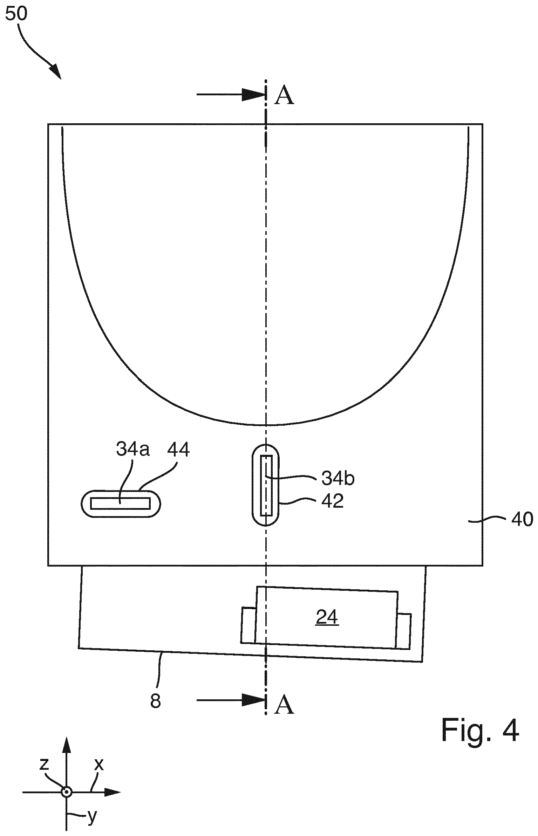

In dem ersten Schritt 4 wird eine Markierung 34a und 34b in Abhängigkeit von der Lage des lichtemittierenden Bereichs 12 auf der Leiterplatte 8 aufgebracht, beispielsweise durch Aufdrucken oder beispielsweise mit einer Lasermarkierung. Vorteilhaft werden für die Lasermarkierung keine weiteren Verbrauchsmittel an der Bestückungsanlage benötigt, wenn ein Laser an der Bestückungsanlage vorhanden ist. Die Markierung 34a ist durch einen Abstand 36 von der Linie 30 beabstandet. Die Markierung 34b ist durch einen Abstand 38 von der Linie 32 beabstandet. Die Markierungen 34a und 34b repräsentieren somit die Lage des lichtemittierenden Bereichs 12. Wie nachfolgend in Figur 4 erläutert, sind die Markierungen 34a und 34b auf eine Referenzgeometrie des optischen Elements abgestimmt.

Zusätzlich oder alternativ kann zu der Markierung 34a und 34b eine weitere Markierung auf der Leiterplatte 8 aufgebracht sein, wie beispielsweise in Form einer maschinenlesbaren Kodierung, die die Lage des lichtemittierenden Bereichs auf der Leiterplatte beschreibt.

Figur 4 zeigt in einer schematischen Draufsicht entgegen einer z-Richtung die Leiterplatte 8 gemeinsam mit dem in z-Richtung darüber angeordneten optischen Element 40. Das optische Element 40 umfasst in z-Richtung Durchgänge 42 und 44. Die Durchgänge 42 und 44 werden jeweils als Referenzgeometrie bezeichnet. Selbstverständlich kann das optische Element 40 auch weitere bzw. andere Referenzgeometrien aufweisen, beispielsweise die Außenkonturen, wie in der Draufsicht gezeigt.

Zur Positionierung des optischen Elements 40 zu der Leiterplatte 8 wurde vorliegend in Figur 4 im Vergleich mit Figur 3 die Leiterplatte 8 in derselben Position gehalten wie in dem ersten Schritt 4. Das optische Element 40 wurde dann in Abhängigkeit von der Lage des lichtemittierenden Bereichs 12 mittels der Markierungen 34a und 34b und der Referenzgeometrien zu der Leiterplatte 8 ausgerichtet. In der in Figur 4 gezeigten Position wird die Leiterplatte 8 mit dem optischen Element 40 verbunden. Die Verbindung des optischen Elements 40 mit der Leiterplatte 8 kann mittels einer Klebung erfolgen. Selbstverständlich kann die Verbindung des optischen Elements 40 mit der Leiterplatte 8 alternativ oder zusätzlich mittels einer Umformung des optischen Elements 40 erfolgen. Zur Umformung des optischen Elements 40 kann dieses bei Ausführung als Kunststoff nach dem Vermessen des verlöteten Halbleiterlichtquellenbauteils 10 zumindest abschnittsweise erhitzt und der Abschnitt zum Angriff an die Leiterplatte 8 und zur zumindest formschlüssigen Verbindung verformt werden. Hierzu können beispielsweise analog zu den Durchgängen 42, 44 Durchgänge in die Leiterplatte 8 in Abhängigkeit von der Vermessung des Halbleiterlichtquellenbauteils 10 eingebracht werden.

Die Positionierung wird in Abhängigkeit von einer Bildermittlung und Bildverarbeitung durchgeführt, wobei bevorzugt ein weiteres Bild entgegen der z-Richtung in der Ausführungsform der Figur 4 aufgenommen und ausgewertet wird. Das optische Element 40 wird demnach derart ausgerichtet, dass die Markierungen 34a, 34b jeweils gleich weit beabstandet in der xy-Ebene zu dem jeweiligen Durchgang 42, 44 sind.

Selbstverständlich sind auch andere Referenzgeometrien 42, 44 des optischen Elements 40, das vorliegend als Reflektor ausgebildet ist, denkbar, womit entsprechend auch andere Markierungen 34a und 34b auf der Leiterplatte angeordnet werden.

Hinsichtlich der Fertigungsschritte kann selbstverständlich auch das optische Element 40 bei und nach der Ermittlung der Lage des lichtemittierenden Bereichs in derselben Position verharren und die Leiterplatte 8 kann nach der Ermittlung und in Abhängigkeit der Lage des lichtemittierenden Bereichs 12 zu dem optischen Element 40 positioniert und mit der Leiterplatte 8 verbunden werden.

Findet die Positionierung und Befestigung des optischen Elements 40 an der Leiterplatte 8 in einem einzigen Fertigungsschritt statt oder aber kann eine definierte Position der Leiterplatte 8 und/oder des optischen Elements gehalten werden, so sind lediglich eine Referenzgeometrie des optischen Elements 40 nötig, um die Leiterplatte 8 ohne Markierung und das optische Element 40 zueinander zu positionieren und miteinander fest zu verbinden.

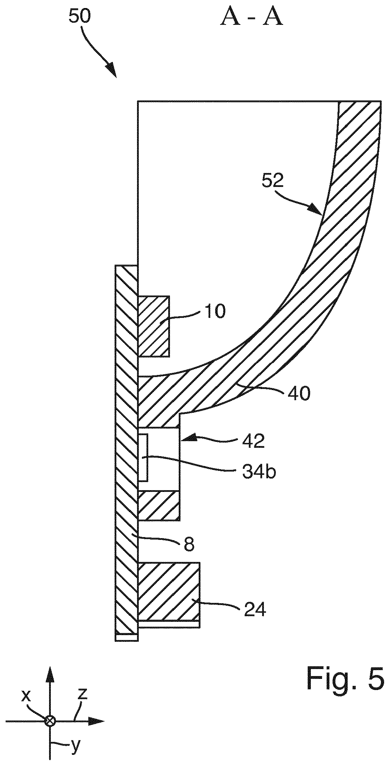

Figur 5 zeigt die Komponente 50 einer Beleuchtungseinrichtung für ein Kraftfahrzeug in einem Schnitt A aus Figur 4 in einer yz-Ebene. Die Komponente 50 umfasst das optische Element 40 und die Leiterplatte 8. Das SMD-Halbleiterlichtquellenbauteil 10 strahlt mit seinem lichtemittierenden Bereich 12 Licht in Richtung des optisch wirksamen Bereichs 52 des optischen Elements 40 ab. Maßgeblich für den Toleranzausgleich ist mithin die Ausrichtung des lichtemittierenden Bereichs 12 des SMD-Halbleiterlichtquellenbauteils 10 zu dem optisch wirksamen Bereich 52 des optischen Elements 40.

Bei der Herstellung des optischen Elements 40 wird bevorzugt der optisch wirksame Bereich 42 von dem gleichen Werkzeug erzeugt und/oder bearbeitet wie die Referenzgeomtrie in Form der Durchgänge 42, 44. Selbstverständlich lässt sich dieser Bearbeitungsschritt auch auf andere Referenzgeometrien beziehen. Darüber hinaus ist es auch möglich, nicht das gleiche Werkzeug zu verwenden, jedoch zumindest zueinander kalibrierte Werkzeuge, um den optisch wirksamen Bereich 52 und den Durchgang 42 bzw. 44 zu bearbeiten bzw. zu erzeugen.

Die Komponente 50 wird in einer Beleuchtungseinrichtung von einem Kraftfahrzeug verbaut. Die Verbindung zu der Beleuchtungseinrichtung wird bevorzugt über das optische Element 40 hergestellt.

## Patentansprüche

1. Verfahren zur Herstellung einer Komponente (50) einer Beleuchtungseinrichtung für ein Kraftfahrzeug, wobei die hergestellte Komponente (50) ein optisches Element (40) und eine Leiterplatte (18) und ein SMD-Halbleiterlichtquellenbauteil (10) umfasst, **dadurch gekennzeichnet, dass** in einem ersten Schritt (4) eine Lage eines lichtemittierenden Bereichs (12) des auf der Leiterplatte (8) angeordneten SMD-Halbleiterlichtquellenbauteils (10) auf der Leiterplatte (8) ermittelt wird, und dass in einem zweiten Schritt (6) das optische Element (40) und die Leiterplatte (8) in Abhängigkeit von der ermittelten Lage des lichtemittierenden Bereichs (12) zueinander positioniert und miteinander verbunden werden.

2. Verfahren nach Anspruch 1, wobei in dem ersten Schritt (4) eine Markierung (34), die die Lage des lichtemittierenden Bereichs (12) repräsentiert, auf die die Leiterplatte (8) aufgebracht wird, und wobei in dem zweiten Schritt (6) das optische Element (40) und die Leiterplatte (8) in Abhängigkeit von der Markierung (34) zueinander positioniert und miteinander verbunden werden.

3. Verfahren nach Anspruch 2, wobei die Markierung (34) zumindest eine Linie umfasst, die im Wesentlichen parallel zu einer Kante des lichtemittierenden Bereichs (12) des SMD-Halbleiterlichtquellenbauteils (10) angeordnet ist, und/oder wobei die Markierung (34) eine maschinenlesbare Kodierung umfasst, die die Lage des lichtemittierenden Bereichs (12) zu der Leiterplatte (8) beschreibt.

4. Verfahren nach einem der vorstehenden Ansprüche, wobei die Verbindung des optischen Elements (40) mit der Leiterplatte (8) mittels einer Klebung und/oder mittels einer Umformung des optischen Elements (40) erfolgt.

5. Verfahren nach einem der vorstehenden Ansprüche, wobei das optische Element (40) eine Referenzgeometrie (42, 44) aufweist, die derart ausgestaltet ist, dass in Abhängigkeit von der Referenzgeometrie (42, 44) das optische Element (40) und die Leiterplatte (8) zueinander ausrichtbar sind.

6. Verfahren nach Anspruch 5 und Anspruch 2 oder 3, wobei die Referenzgeometrie (42, 44) des optischen Elements (40) zu der Markierung (34) auf der Leiterplatte (8) korrespondiert.

7. Verfahren nach Anspruch 5 oder 6, wobei die Referenzgeometrie (42, 44) des optischen Elements (40) von demselben Werkzeug erzeugt und/oder bearbeitet wird wie ein für das SMD-Halbleiterlichtquellenbauteil (10) optisch wirksamer Bereich (52) des optischen Elements (40).

8. Verfahren nach einem der vorstehenden Ansprüche, wobei das optische Element (40) eine Vorsatzoptik und/oder eine Blende umfasst.

9. Komponente (50) einer Beleuchtungseinrichtung für ein Kraftfahrzeug umfassend ein optisches Element (40) und eine Leiterplatte (8) mit einem SMD-Halbleiterlichtquellenbauteil (10), wobei die Komponente (50) nach einem der vorstehend erläuterten Verfahren hergestellt ist.

10. Beleuchtungseinrichtung für ein Kraftfahrzeug umfassend eine Komponente (50) nach dem vorstehenden Anspruch, wobei die Komponente (50) über das optische Element (40) mit der Beleuchtungseinrichtung verbunden ist.

## Claims

1. A method for producing a component (50) of a lighting device for a motor vehicle, wherein the produced component (50) comprises an optical element (40), a circuit board (18), and a SMD semiconductor light source element (10), **characterized in that**, in a first step (4), a position of a light emitting region (12) of said SMD semiconductor light source element (10) arranged on said circuit board (8) is determined, and that, in a second step (6), said optical element (40) and said circuit board (8) are positioned relative to each other and connected to one another based on the determined position of said light emitting region (12).

2. The method according to claim 1, wherein, in said first step (4), a marking (34) representing the position of said light emitting region (12) is applied to said circuit board (8), and wherein, in said second step (6), said optical element (40) and said circuit board (8) are positioned relative to each other and connected to one another based on said marking (34).

3. The method of claim 2, wherein said marking (34) comprises at least one line arranged substantially in parallel to an edge of said light emitting region (12) of said SMD semiconductor light source element (10), and/or wherein said marking (34) comprises a machine-readable encoding that describes the position of said light emitting region (12) with respect to said circuit board (8) .

4. The method according to any one of the preceding claims, wherein the connection of said optical element (40) with said circuit board (8) is achieved by means of an adhesive bond and/or by means of a deformation of said optical element (40).

5. The method according to any one of the preceding claims, wherein said optical element (40) has a reference geometry (42, 44) which is configured such that said optical element (40) and said circuit board (8) can be aligned with each other based on said reference geometry (42, 44).

6. The method according to claim 5 and claim 2 or 3, wherein said reference geometry (42, 44) of said optical element (40) corresponds to said marking (34) on said circuit board (8).

7. The method according to claim 5 or 6, wherein said reference geometry (42, 44) of said optical element (40) is produced and/or machined by the same tool as an optically effective region (52) of said optical element (40) for said SMD semiconductor light source element (10) .

8. The method according to any one of the preceding claims, wherein said optical element (40) comprises an auxiliary optics and/or a diaphragm.

9. A component (50) of a lighting device for a motor vehicle comprising an optical element (40) and a circuit board (8) with a SMD semiconductor light source element (10), wherein said component (50) is produced according to one of the methods disclosed above.

10. A lighting device for a motor vehicle comprising a component (50) according to the preceding claim, wherein said component (50) is connected to said lighting device via said optical element (40).

## Revendications

1. Procédé de fabrication d'un composant (50) d'un dispositif d'éclairage pour véhicule automobile, dans lequel le composant (50) fabriqué comprend un élément optique (40) et une carte de circuits imprimés (18) et un composant CMS à source lumineuse à semi-conducteurs (10), **caractérisé en ce que**, lors d'une première étape (4), on détermine sur la carte de circuits imprimés (8) une position d'une région émettrice de lumière (12) du composant CMS à source lumineuse à semi-conducteurs (10) disposé sur la carte de circuits imprimés (8), et **en ce que**, lors d'une seconde étape (6), l'élément optique (40) et la carte de circuits imprimés (8) sont positionnés l'un par rapport à l'autre en fonction de la position déterminée de la région émettrice de lumière (12) et reliés entre eux.

2. Procédé selon la revendication 1, dans lequel, lors d'une première étape (4), un marquage (34) qui représente la position de la région émettrice de lumière (12) est appliqué sur la carte de circuits imprimés (8), et dans lequel, lors d'une seconde étape (6), l'élément optique (40) et la carte de circuits imprimés (8) sont positionnés l'un par rapport à l'autre en fonction du marquage et reliés entre eux.

3. Procédé selon la revendication 2, dans lequel le marquage (34) comprend au moins une ligne qui est disposée de manière sensiblement parallèle à un bord de la région émettrice de lumière (12) du composant CMS à source lumineuse à semi-conducteurs (10), et/ou dans lequel le marquage (34) comprend un codage lisible par machine qui décrit la position de la région émettrice de lumière (12) par rapport à la carte de circuits imprimés (8).

4. Procédé selon l'une des revendications précédentes, dans lequel la liaison de l'élément optique (40) avec la carte de circuits imprimés (8) s'effectue par collage et/ou par une déformation de l'élément optique (40).

5. Procédé selon l'une des revendications précédentes, dans lequel l'élément optique (40) présente une géométrie de référence (42, 44) qui est configurée de telle sorte qu'en fonction de la géométrie de référence (42, 44), l'élément optique (40) et la plaque de circuits imprimés (8) peuvent être alignés l'un par rapport à l'autre.

6. Procédé selon la revendication 5 et la revendication 2 ou 3, dans lequel la géométrie de référence (42, 44) de l'élément optique (40) correspond au marquage (34) sur la plaque de circuits imprimés (8).

7. Procédé selon la revendication 5 ou 6, dans lequel la géométrie de référence (42, 44) de l'élément optique (40) est produite et/ou usinée par le même outil qu'une région (52) de l'élément optique (40) optiquement active pour le composant CMS à source lumineuse à semi-conducteurs (10).

8. Procédé selon l'une des revendications précédentes, dans lequel l'élément optique (40) comprend une optique additionnelle et/ou un diaphragme.

9. Composant (50) d'un dispositif d'éclairage pour véhicule automobile, comprenant un élément optique (40) et une plaque de circuits imprimés (8) dotée d'un composant CMS à source lumineuse à semi-conducteurs (10), le composant (50) étant fabriqué selon l'un des procédés exposés ci-avant.

10. Dispositif d'éclairage pour véhicule automobile, comprenant un composant (50) selon la revendication précédente, le composant (50) étant relié au dispositif d'éclairage par l'intermédiaire de l'élément optique (40) .
